# EUROPEAN PATENT APPLICATION

(11) **EP 1 677 133 A1**
(43) Date of publication of application: **05.07.2006**
(21) Application number: 05258009.9
(22) Date of filing: 22.12.2005
(51) Int. Cl.: G02B 7/00, B81B 3/00, G02B 6/36, G02B 7/02

(54) **Microcomponent holder and method for manufacture thereof**

(30) Priority: 30.12.2004 US 640741 P
(71) Applicant: Rohm and Haas Electronic Materials, L.L.C., Marlborough, Massachusetts 01752 (US)
(72) Inventor: Fisher, John J., Blacksburg, Virginia 24060 (US)
(74) Representative: Kent, Venetia Katherine

(57) **Abstract**

Provided is a microcomponent holder for retaining a micro-scale component The microcomponent holder includes at least one aperture for receiving a micro-scale component therein. At least one loop-shaped support member is disposed about the aperture for contacting the micro-scale component to retain the micro-scale component within the microcomponent holder. The invention allows for retaining of microseale objects, such as lenses or other parts of micro-optical, micro-mechanical, micro-electromechanieal, and other micro-scale systems.

## Description

### Background of the Invention

The present invention relates to microscale apparatus for retaining microscale objects, such as lenses or other parts of micro-optical, micro-mechanical, micro-electromechanical, and other micro-scale systems. The present invention also relates to methods for making such apparatus.

Conventional optical systems typically comprise various discrete components such as light sources, detectors, lenses, gratings, mirrors, beam splitters, modulators, filters, polarizers, collimators, shutters, choppers, and so forth. Such conventional components usuatly have dimensions on the order of a centimeter or larger. Thus, in conventional systems, discrete components are positioned and aligned on optical benches using precisely machined centimeter-scale parts such as fixtures or grips that serve as holders, mounts, adjustable positioners, and alignment tools for the various optical components. However, new generations of optical systems have been drastically miniaturized and utilize optical components with dimensions on the scale of tens of microns or smaller, which are not compatible with conventional fixtures or grips. The manipulation of such micro-optical components, specifically with regard to their relative positioning, alignment and orientation, is often problematic. In addition, many emerging applications impose challenging and increasingly demanding requirements on such microcomponent holders, especially with regard to their compatibility with the variable shapes and small dimensions of the components being manipulated, as well as with respect to the precision and accuracy of their manipulation. Furthermore, additional considerations for such microcomponent holders include their ease of use, manufacturability, reproducibility, and cost. Thus, there is a need for better apparatus for handling and mounting such micro components. These needed apparatus, include, for example, gripping tools for holding and manipulating components. Specifically, there is a need for apparatus into which microcomponents can be loaded for either releasably mounting or permanent or semi-permanent mounting. The apparatus may themselves be incorporated along with their loaded components into a system or instrument as part of its manufacture or assembly.

For example, an important and representative application in which microcomponent holders are needed involves photodiodes and laser diodes. These semiconductor devices have die dimensions ranging from tens to several hundred microns, and often have photosensitive areas or emissive surfaces of only a few microns in extent. The detectors and laser diodes are typically coupled to optical systems by positioning a microlens of comparable dimensions in close proximity to the laser or detector. Hence, for effective optical coupling, the placement and alignment within sub-micron tolerances of such components is desired with regard to accuracy, consistency, and reproducibility. Further, it is often desired that such devices be capable of mass production with high precision at low-cost. Currently, expensive and tedious micromanipulataon systems employing scanning, real-time optical measurements and feedback are used to align semiconductor devices and other microscale optical components. Thus, there is a need for microcomponent holders that permit low cost and accurate mounting of a microcomponent within the holder.

### Summary of the Invention

In accordance with a first aspect of the invention, provided is a microcomponent holder for retaining a micro-scale component. The microcomponent holder includes at least one aperture for receiving a micro-scale component therein. At least one loop-shaped support member is disposed about the aperture for contacting the micro-scale component to retain the micro-scale component within the microcomponent holder.

In accordance with a further aspect of the invention, provided is a microcomponent holder for retaining a micro-scale component. The microcomponent lzolder includes at least one aperture for receiving a micro-scale component therein. At least one support member is disposed at the aperture for contacting the micro-scale component to retain the micro-scale component within the microcomponent holder. A reference surface is disposed at a selected location relative to the aperture to facilitate positioning the micro-scale component at a selected location in an assembly.

### Brief Description of the Drawings

The foregoing summary and the following detailed description of the preferred embodiments of the present invention will be best understood when read in conjunction with the appended drawings, in which:
FIG. I schematically illustrates a microcomponent holder in accordance with the present invention having a flat mounting surface and having three inwardly-directed, loop-shaped support members for retaining a microcomponent within the holder;
FIG. 2 schematically illustrates the annular lens holder of FIG. 1 but with a microlens disposed therein;
FIG. 3 schematically illustrates another microcomponent holder in accordance with the present invention having several peripheral flat mounting surfaces, and having three support members in the shape of a spiraling arms for retaining a microcomponent within the holder;
FIG. 4 schematically illustrates an oblique view of a lens holder with several sockets that are positioned in opposition to similar shaped sockets on a platform, and with balls seated in corresponding sockets of the lens holder and platform that function as self-aligning standoffs for the lens holder;
FIG. 5 schematically illustrates a top perspective view of the lens holder shown in FIG. 4;
FIG. 6 schematically illustrates a tiered arrangement of several lens holders stacked in parallel configuration to position and align several optical components; and
FIG. 7a-h shows a process flow description for microfabrication of a microlens holder using lithography and reactive ion dry etching;

### Detailed Description of the Invention

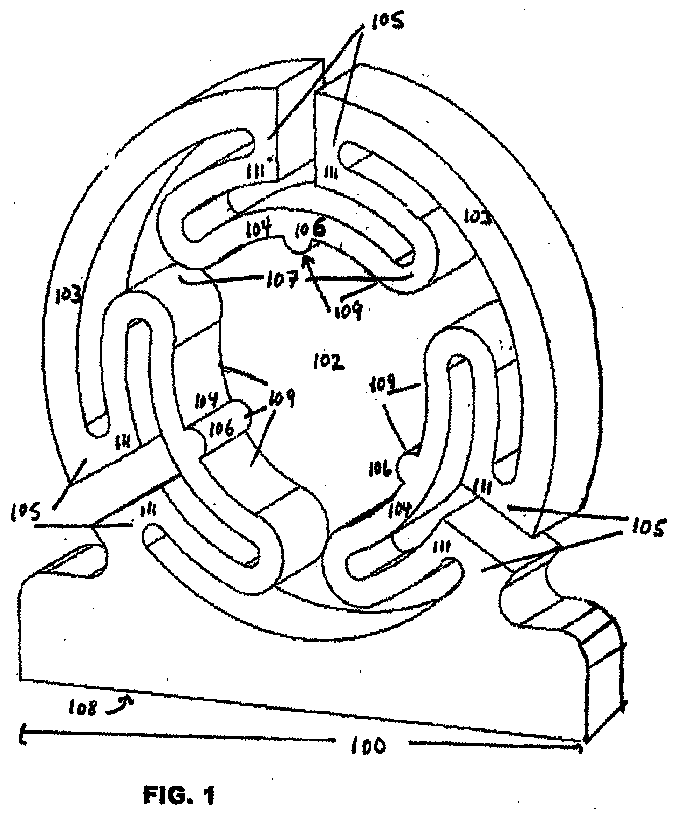

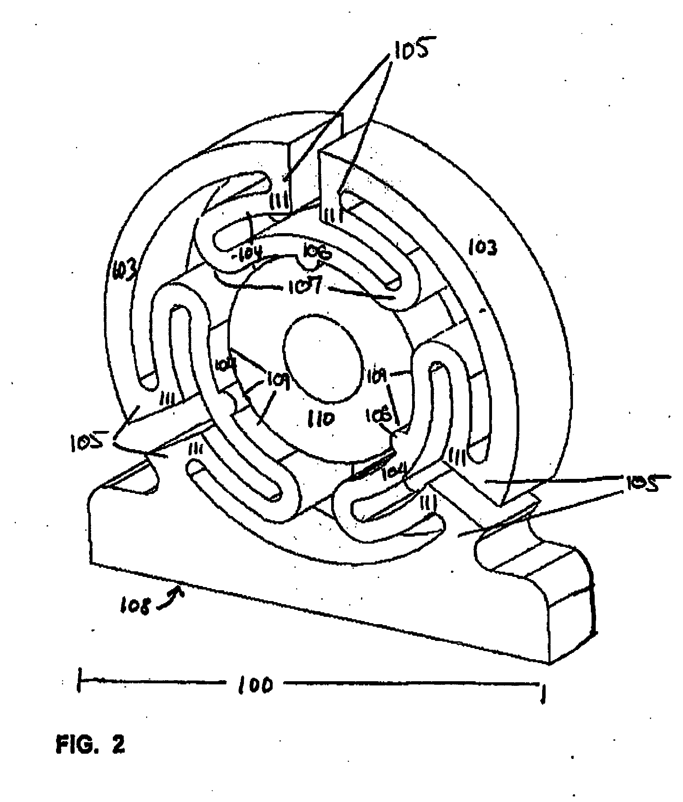

Referring now to the figures, wherein like elements are numbered alike throughout, and in particular in FIGS. 1 and 2, a microcomponent holder 100 in accordance with the present invention is shown. The holder 100 may have a generally annular shape and may include annular outer segments 103 disposed about the periphery of the holder 100. The microcomponent holder 100 may also include one or more support members 104 which extend inwardly from the outer annular segments 103 of the holder 100 for retaining a microcomponent within the holder 100. The support members 104 may be configured to provide an aperture 102 therebetween into which a microcomponent 110, such as a microlens, may be positioned and retained by the holder 100. As illustrated in FIG. 1, the aperture 102 may have a generally circular or other suitable shape.

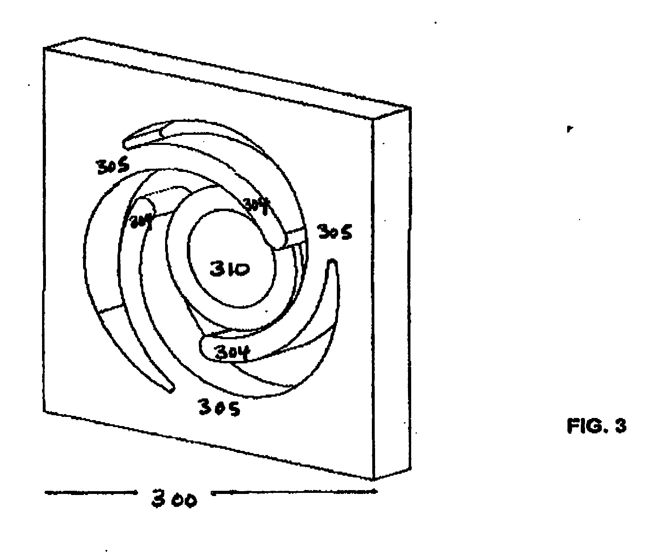

For example, the support members 104 may be loop-shaped and have two ends 111 I that are monolithicaUy joined to the outer annular segments 103 at fulcrums 105. Alternatively, as illustrated in .FIG. 3, a microcomponent holder 300 may include cantilevered support members 304 that have the shape of a spiral arm with a single point of monolithic joinder to the periphery of the holder 300 at a fulcrum 305.

Returning to the configuration of FIG. 1, the support members 104 may include a central loop portion 107 which includes a mounting surface 109 that may have a complementary shape to that of the microcomponent to be retained in the holder 100. For example, as illustrated in FIG. 2, the central loop portions 107 may have an arcuate shape suitable for engagement with a circular microcomponent, such as microlens 110. Alternatively, the support members 104 may have other shapes suited to holding particularly shaped microcomponents. The support members 104 may further include a recessed area, such as a groove, or may include a protrusion, such as a tab 106, to assist in retaining the microcomponent in the holder 100. In the particular configuration illustrated, the three support members 104 have tabs 106 that contact the sides of the micro component 110 at three equiangular positions around the periphery of the microcomponeut 110.

The support members 104 may deform, for example in the radial direction, upon placement of the microcomponent 110 within the aperture 102 so that the support members 104 conform to the shape of the microcomponent 110 to thereby assist in securely retaining the microcomponent 110 within the holder 100. The support members 104 may be designed to deform by virtue of their shape, size, and material of construction. In particular, the support members 104 may elastically or inelastically deform. For instance, the support members 104 may resiliently deform to function like a spring and provide a force against the microcomponent 110 to retain a microcomponent within the holder 100. For example, for an annular holder such as holder 100, the support members 104 may be configured to provide a radially inward forced directed towards the center of the aperture 102. In particular, it may be desirable to configure the support members 104 to permit self-centering of the microcomponent 110 within the holder 100. For example, as shown in FIGS. 2 and 3, the support members 104, 304 may be symmetrically disposed about the center of the aperture so that a circular microcomponent 110, 310 is self-centered within the aperture.

The holder 100 may also desirably include one or more reference surfaces 108, such as an edge, disposed at a fixed, known location relative to the center of the aperture 102 so that the retained microcomponent 110 may be placed at a known location relative to other components in a system based on the position of the reference surface 108 within the system. In this regard, the holder 100 may desirably comprise a monolithic part that includes the annular segments 103, support members 104, and reference surface 108. Provision of a monolithic part promotes accurate location between the reference mounting surface 108 and support members 104 thereby avoiding potential alignment errors associated with assembling discrete components. A monolithic holder may be fabricated from materials amenable to micromachining and/or photlithographic processes, such as a silicon wafers.

The reference surface 108 may be located on the periphery of the holder 100, or interior to the periphery and may have any shape suited to providing a reference on the holder 100 from which the location of a desired feature of the microcomponent 110 can be determined. For example, the reference surface 108 may include a flat surface disposed at a known position relative to the center of the aperture 102, as shown in FIGS. 1-3. The reference surface 108 may desirably include a structure that is not rotationally symmetric about the center of the aperture 102, such as a flat surface, so that a unique angular orientation of the holder 100 may be determined. Such a configuration may be particularly desirable for use with microcomponents that have rotationally asymmetric properties, such as a linear polarizer. The reference surface 10$ may also provide a mounting surface, and in this regard may be seated in a slot to aid proper positioning. Further, the microcomponent holder 100 may be translated and aligned on the surface of a baseplate, by seating the reference surface 108 in a groove that allows motion in one dimension.

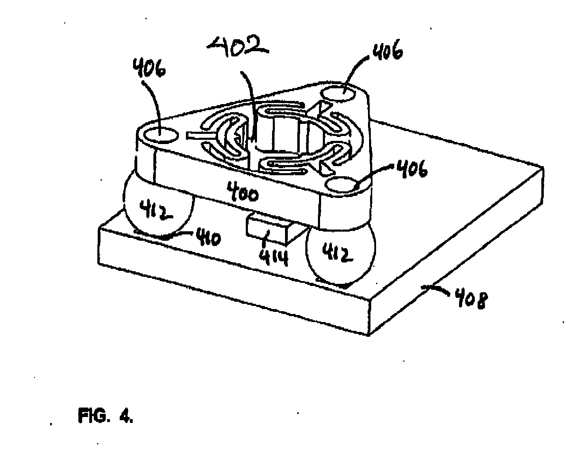

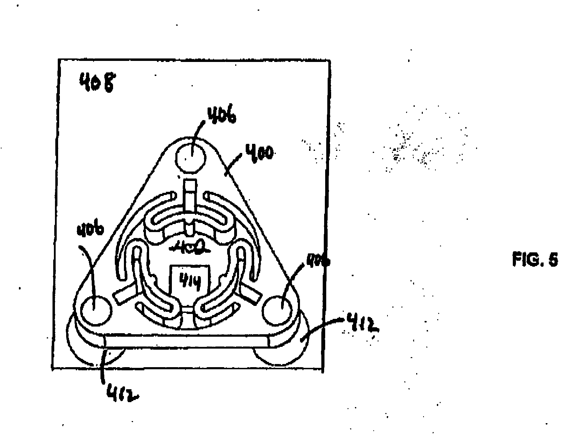

Alternatively, as shown in FIGS. 4 and 5, one or more reference surfaces may be provided interior to the microcomponent holder 400 in the form of sockets 406, for example. The sockets 406 may comprise cylindrical holes through the microcomponent holder 400 suitable for receiving registration elements such as microspheres 412. The microcomponent holder 400 can be aligned with respect to a baseplate 408 which has depressions 410 configured to receive the microspheres 412. The depressions 410 are located in the baseplate 408 in a corresponding arrangement to the sockets 406 of the micro component holder 400 so that each microsphere 412 may be seated within a holder socket 406 and an opposing baseplate depression 410. With each of the microspheres 412 engaged between an opposing socket 406/depression 410 pair, the microcomponent holder 400 will resist further translational or rotational motion relative to the baseplate 408, thus effecting alignment of the microcomponent holder 400 with the baseplate 408. Thus, a microcomponent, such as a lens, retained within an aperture 402 of the holder 400 can be optimally positioned and optically coupled to a microcomponent 414, such, as a detector or laser diode, mounted on the baseplate 408.

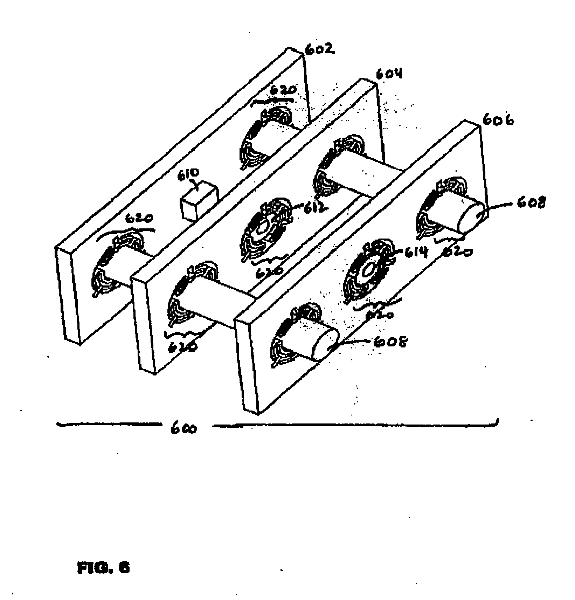

In yet a further aspect of the present invention, FIG. 6 shows a tiered arrangement 600 of microcomponent holders, with the use of multiple microcomponent holder plates 602, 604, 606, each comprising one or more microcomponent holders 620, and each realized as annular-shaped apertures with structural elements that abut and hold a microcomponent 610, 612,614, similar or analogous to that as described with respect to FIGS. 1-3. The holder plates 602, 604, 606 are connected to one another using mountings elements 608, such as tods, that function as alignment pins and/or support columns which may be retained within respective microcomponent holders 620 of the holder plates 602, 604, 606 to offset the holder plates 602, 604, 606 to form an evenly spaced tier of plates. In addition, one or more of the microcomponent holders 620 of each holder plate 602, 604, 606 may be loaded with microcomponents 610, 612, 614. Such an assembly of stacked microcomponent holders 620 permits multiple microcomponents to be accurately aligned along a common optical axis, for example. For instance, a microcomponent, such as a die 610, may be bonded to a selected holder plate 602 and aligned with microcomponents 612, 614, e.g., lenses, disposed on other holder plates 604,606. The die 610 may include may include, for example, a detector, laser diode, or light-emitting diode. The spacing between plates may be adjusted by applying a force parallel to the alignment rods to slide the holder plates along the rods. Optionally, micro component holders 620 of the same configuration may be used to retain mounting elements 608 as well as the microcomponents 612, 614. That is, the microcomponent holders 620 may be configured to accept either a microcomponent 612, 614, such as a microlens, or an alignment rod 608, as depicted in FIG. 6.

The monolithic, microcomponents described above may be made by microfabriaction technologies including lithography and dry etching, for example, reactive-ion-etching, of polished silicon wafers, such as those used to make semiconductor devices. In the present invention, the etching may be used to selectively and completely remove portions of silicon unprotected by photoresist. As such, designs for microcomponent holders, and in particular for mounting elements, may desirably rely on the continuity of all geometric features, and in particular, the mounting elements may be contiguous with the annular portions of the device. In this regard, the shape and dimensions of the mounting element, along with the thickness of the wafer and the intrinsic mechanical properties determine the elastic behavior and utility of the mounting element in clamping objects of variable shape and size.

The microcomponent holder can be made by a number of techniques. The following examples offer three approaches that are representative of feasible methods to realize microcomponent holders. However, it will be understood to those skilled in the art that there are numerous modifications of these processes, as well as alternative processes and techniques, that would also be workable.

### Example 1: Fabrication of Metal Microcomponent Holder by Electroforming:

A microcomponent holder can be made by electroforming techniques, whereby a metal holder structure is formed by electroplating metal onto a template that is lithographically-defined in a photoresist coating deposited on a supporting substrate. The shape of the electroplated metal part conforms to the topography of the patterned photoresist layer. The electroformed part is then separated from the photoresist-coated substrate, somewhat akin to releasing a cast workpiece from a mold.

To make the template used to electroform the microcomponent holder, photoresist is applied to an electrically-conductive substrate, such as a doped silicon wafer. Typically, the silicon wafer is first coated with a thin (e.g., 50-200 Å) conductive metal layer (e.g., Ti, Cr) deposited by evaporative coating or sputtering. This first-deposited metal layer is then coated with a second conductive layer, such as a film of gold, platinum, copper, or nickel, with a thickness typically ranging from 150-400 Å. The second layer functions as a 'priming' or 'seeding' layer that promotes adhesion to the substrate and provides an electrically conductive path for the plating process. Next, the conductive substrate is coated with a thick (e.g., 30-400 microns) photoresist, that serves as a mask in a subsequent electroplating step. The photoresist is patterned by photolithography techniques. The patterning produces openings in the photoresist mask that expose selected areas of the substrate to an electrolytic plating solution upon immersion of the substrate in a plating bath. To plate the metal, the substrate is immersed in an electroplating bath containing a solution with metal component(s). The backside of the substrate (opposite the side of the substrate bearing the photoresist layer) is connected to an electric power supply so that the substrate functions as an electrode in an electrolytic plating reaction. A second electrode is also immersed in the plating bath. The polarity and magnitude of a voltage difference imposed between the substrate and second electrode is such that the substrate functions as a cathode and the second electrode functions as an anode in an electrolytic plating reaction wherein metal constituents of the plating bath solution are deposited on the cathodic substrate. Because the photoresist layer is electrically insulating, there is virtually no electro-deposition of metal on the photoresist layer itself. On the other hand, parts of the photoresist layer that have been removed in the patterning process and where, as a result of said patterning, areas of the underlying substrate are exposed to the plating solution will witness preferential electroplating of metal. Typically, nickel is used as the electroplated metal although other plated metals such as gold, copper, nickel-iron, nickel-cobalt and other alloys may be used.

To increase the thickness of the electroformed part, several plating and photolithography patterning steps may be performed in succession. The final step is to release the microcomponent holder from the substrate wafer, as for example by dissolving the photoresist layer. In practice, the photoresist pattern will define a multitude of microcomponent holders that will be electroformed simultaneously on the same wafer in the plating process, and further several or more wafers can be processed in a batch operation. Thus, a large number of microcomponent holders can be manufactured in a cost effective manner with a high degree of reproducibility and consistency between individual components.

### Example 2: Fabrication of Silicon lViicrocomyoonent Holder by Etching:

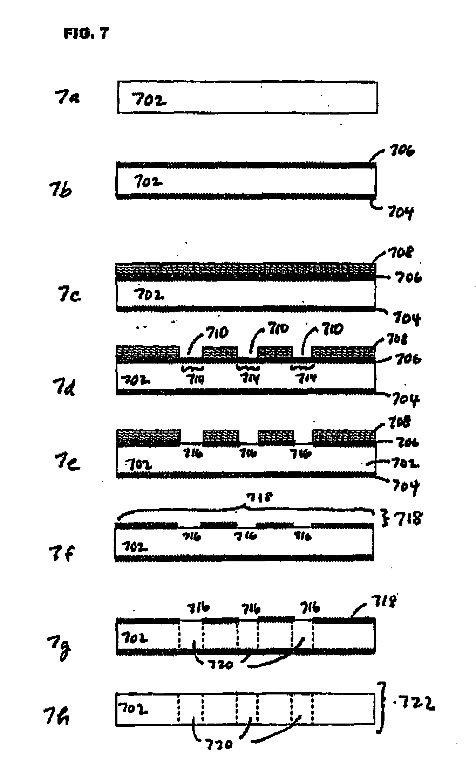

The following process, shown schematically in FIG. 7 where side-view cross-sections of the workpiece in successive stages of fabrication are depicted, can be used to shape a microcomponent holder from a silicon wafer according to the designs disclosed herein.

As in FIG- 7a, the starting material is a silicon wafer 702. The thickness of the wafer depends on the targeted ultimate thickness of microcomponent part and its desired mechanical properties, and typically will be in the range of 400 to 1000 microns. Suitable silicon wafers are commonly used and commercially available in the microelectronics industry for fabrication of silicon semiconductor devices and integrated circuits.

The wafer is cleaned, for example, with an oxygen plasma. In the next step (FIG. 7b), 200 nm thick aluminum masking layers 704, 706 are deposited on both sides of the wafer 702 using sputter deposition, or thermal or electron-beam evaporation. The aluminum layer 704 formed on one side of the wafer, referred to as the backside of the wafer 702, acts as an etch-stop layer, i.e., a protective barrier coating that is particularly resistant to subsequent silicon etching processes. The side of the wafer 702 opposite the backside is referred to as the frontside of the wafer. An aluminum masking layer 706 on the frontside of the wafer provides a similar etching barrier function to be patterned to serve as a stencil during etching of the silicon substrate. Other metals such as chrome, or dielectric layers including silicon dioxide formed by thermal oxidation of the silicon surface, can also be used as etch masks, for example. Silicon-on-insulator (SOI) wafers which contain an embedded oxide layer below one surface of the silicon wafer, and wafers with resist masks can also be used. The best thickness of metal or dielectric mask layers is highly dependent on the characteristics of the silicon etching step used to shape the microcomponent holder.

In the next step (FIG. 7c), a photoresist layer 708 is applied to the frontside of the wafer 702 and exposed with ultraviolet light through a photolithography mask in a mask aligner system. The photoresist layer 708 is developed with a commercial developer solution and baked. As shown in FIG. 7d, the process steps of exposure and development selectively remove areas to provide openings 710 of the photoresist layer 708 according to a pattern defined by the photolithography mask through which the workpiece is exposed. The aluminum areas 714 unprotected by the photoresist layer 708 are then etched from the silicon wafer 702 with a phosphoric acid solution, leaving exposed silicon surfaces 716 according to the photoresist mask openings 710, as indicated in FIG. 7e. At this stage of the process corresponding to FIG. 7f, the photoresist has served its purpose and can be stripped from the workpiece using solvents recommended by the photoresist manufacturer, leaving a silicon wafer 702 protected on the back side by continuous metal film 704 and on the opposing frontside by a metal mask stencil 718, realized by lithographic patterning of metal film 706.

As indicated in FIG. 7g, the silicon wafer 702 with the patterned aluminum mask 718 defining the microcomponent holder shape is then subjected to a 'dry' reactive ion etch (RIE) process which removes silicon in areas 716 not protected by the aluminum mask. The reactive ion etch may be performed according to the Bosch process (F. Laermer and A. Schilp, "Method of Anisotropically Etching Silicon", Robert Bosch GmbH: U.S. Patent No. 5,501,893, which is incorporated herein by reference.). The reactive ion etching shapes the silicon wafer 702 according to the pattern defined by the photolithography mask 718. The silicon etching sculpts the wafer 702 completely etching through the wafer 702 in selected areas 720.

After reactive-ion etching, and as shown in FIG. 7h, the metal masks 704, 706 from both sides of the silicon wafer 702 are then stripped from silicon wafer 702 using, for example in the case of aluminum masks, a hydrochloric acid etchant. According to the designs, the silicon remaining after the etch step is a single continuous piece 722 with sufficient structural stability. Commonly, a portion of the periphery of the silicon wafer is protected and preserved in the etching to facilitate handling. Typically, a photolithography mask with multiple, repeated patterns for plural microcomponent holders is used so that many holders can be fabricated simultaneously. The individual lens (or other microcomponent) holders are then singulated from the silicon workpiece by cleaving or dicing the silicon wafer 702.

### Example 3: Fabrication of Polymer Microcomponent Holder:

As a third example of a method for fabricating microcomponent holders, a structural photoresist is patterned in the shape of the component. In this case, the photoresist is not merely a means by which the microcomponent holder member is shaped, but rather the component is comprised of the photoresist material itself. That is, the photoresist is non-sacrificial. A thick layer of photoresist is applied to a substrate. The photoresist is patterned, developed, and hardened. The shaped photoresist is then separated from its substrate, yielding a tree-standing microcomponent holder. Structural photoresists such as SU-8 (Microchem, Inc., Newton, MA) are well-suited for this task. SU-8 is an epoxy-type, near-UV sensitive photoresist that can be processed in thicknesses in excess of 1 millimeter, while achieving sufficient aspect ratios.

It will be recognized by those skilled in the art that changes or modifications may be made to the above-described invention without departing from the broad inventive concepts of this invention. It is understood, therefore, that the invention is not limited to the particular embodixnents disclosed herein, but is intended to cover all modifications and changes which are within the scope of the invention as defined in the appended claims.

## Claims

1. A microcomponent holder for retaining a micro-scale component, comprising:
at least one aperture for receiving a micro-scale component therein; and
at least one loop-shaped support member disposed about the aperture for contacting the micro-scale component to retain the micro-scale component within the microcomponent holder.

2. The microcomponent holder of claim 1, further comprising a reference surface disposed at a selected location relative to the aperture to facilitate positioning the micro-scale component in an assembly.

3. The microcomponent holder of claim 2, wherein the reference surface comprises a flat edge, a depression, or a throughhole.

4. The micro component holder of any of claims 1-3, wherein the microcomponent holder comprises silicon.

5. The microcomponent holder of any of claims 1-4, wherein the at least one support member is resilient for springingly retaining the component within the holder.

6. The micro component holder of any of claims 1-5, wherein the at least one support member is deformable to accommodate a component having a size larger than that of the aperture.

7. The microcomponent holder of any of claims 1-6, comprising a plurality of said support members, wherein the support members are disposed about an annular ring.

8. The microcomponent holder of any of claims 1-7, wherein the at least one aperture comprises two apertures, and wherein the holder comprises a first mounting member comprising the first aperture and second mounting member comprising the second aperture, and wherein the holder comprises a rod disposed in the first and second apertures to align the first and second mounting members.

9. A microcomponent holder for retaining a micro-scale component, comprising:
at least one aperture for receiving a micro-scale component therein;
at least one support member disposed at the aperture for contacting the micro-scale component to retain the micro-scale component within the microcomponent holder; and
a reference surface disposed at a selected location relative to the at least one aperture to facilitate positioning the micro-scale component at a selected location in an assembly.

10. The microcomponent holder of claim 9, wherein the support member comprises a cantilever.
